# EUROPÄISCHE PATENTANMELDUNG

(11) **EP 2 159 917 A1**
(43) Veröffentlichungstag der Anmeldung: **03.03.2010**
(21) Anmeldenummer: 08105203.7
(22) Anmeldetag: 02.09.2008
(51) Int. Cl.: H03K 17/955

(54) **Näherungssensor**

(71) Anmelder: Hella KGaA Hueck & Co., 59552 Lippstadt (DE)
(72) Erfinder: Weghaus, Ludger, 59556 Lippstadt (DE); Kirchhoff, Friedhelm, 59597 Erwitte (DE); Marx, Bernhard, 59590 Geseke (DE)

(57) **Zusammenfassung**

Die Erfindung betrifft einen Näherungssensor, dessen Herstellung vereinfacht werden soll. Dies wird dadurch erreicht, dass dass ein elektrischer Anschluss der Elektroden an die Elektronik kontaktlos erfolgt.

## Beschreibung

Die Erfindung betrifft einen Näherungssensor gemäß dem Oberbegriff des Anspruchs 1.

Solche Näherungssensoren sind an sich bekannt und werden z.B. in Kraftfahrzeugen eingesetzt, um z.B. Sicherheitsfunktionen zu überwachen. Weiterhin gibt es für Kraftfahrzeuge Bestrebungen, berührungslos und automatisch Öffnungs- und/oder Schließfunktionen von z.B. Schiebetüren oder Heckklappen zu realisieren.

Hierfür ist es bei einem verriegelten Kraftfahrzeug einerseits erforderlich, dass es über ein System zum schlüssellosen Zugang (keyless entry) verfügt. Dieses System erlaubt das Öffnen einer Tür des Kraftfahrzeugs, ohne dass ein Schlüssel benutzt werden muss. Vielmehr genügt es, wenn eine Person einen elektronischen "Schlüssel" bei sich trägt, der eine dem Kraftfahrzeug entsprechende Identifizierung aufweist und so eine Verriegelung bei einer vorbestimmten Annäherung entsperrt. Bei einem entriegelten Kraftfahrzeug genügt bereits die vorbestimmte Annäherung.
Andererseits muss die automatische Steuerung ein Signal erhalten, ob und welche Tür oder Klappe automatisch betätigt, also geöffnet oder geschlossen werden soll. Hierfür müssen Näherungssensoren derart zugeordnet sein, dass eine unbeabsichtigte Betätigung unwahrscheinlich ist. Daher sind diese Näherungssensoren vorzugsweise im Bereich der zu betätigenden Tür oder Klappe möglichst bodennah so angeordnet, dass sie einen Fuß oder Unterschenkel ab einer vorbestimmten Entfernung erkennen.
Auf diese Weise ist ein automatisches Betätigen der Tür oder Klappe möglich, ohne dass die Person ihre Hände zur Hilfe nehmen muss.

Elektroden sind z.B. in metallischer länglicher Ausführung bekannt. Sie werden in Kunststoffteile eingebettet oder aufgeklebt. Dies ist entsprechend aufwändig.

Die Elektroden sind üblicherweise mittels angelöteter Steckdosen oder anderer Kontakte an eine elektronische Auswerteschaltung angeschlossen. Dies ist mit entsprechendem Aufwand verbunden.
Aber auch die kontaktlose Übertragung von Energie und/oder Signalen ist an sich bekannt.

Aus der DE 195 00 925 C2 ist ein Verfahren zum Herstellen einer Chipkarte bekannt. Die Chipkarte ist zur kontaktlosen Übertragung von Daten in ein Lesegerät eingerichtet. In der Karte ist eine Antenne zur induktiven oder kapazitiven Daten- und Energieübertragung angeordnet. Der Chip wird erst nach einer Qualitätskontrolle der Karte in diese eingesetzt und elektrisch leitend mit der Antenne verbunden. Dieses Verbinden ist mit einigem Aufwand verbunden.

Die DE 38 52 308 T beschreibt eine kontaktlose Energiezufuhr- und Empfangsvorrichtung. Die Vorrichtung ist aufwändig und für Kraftfahrzeuge nicht verwendbar.

Es ist Aufgabe der Erfindung, einen Näherungssensor zu schaffen, dessen Elektroden einfach an die zugehörige Elektrik/Elektronik anzuschließen sind.

Die Aufgabe ist durch die Merkmale des Anspruchs 1 gelöst. Ein elektrischer Anschluss der Elektroden erfolgt kontaktlos. Da lediglich wenige Elektronen zu bewegen sind, spielt die Leitfähigkeit für den Näherungssensor nur eine untergeordnete Rolle. Der kontaktlose Anschluss ist einfach herzustellen, weil lediglich auf eine ausreichend genaue Positionierung der Koppelfläche zu der Elektrode zu achten ist. Dies ist durch Anbringung entsprechender Positionsmarken möglich, die gleichzeitig eine Befestigung für erforderliche Bauteile wie z.B. eine Leiterplatte darstellen können. An den Elektroden sind keine Lötarbeiten oder sonstige aufwändigen Maßnahmen zur Kontaktierung erforderlich. Eine Verkabelung zwischen den Elektroden und der Elektronik kann entfallen.

Die Unteransprüche betreffen die vorteilhafte Ausgestaltung der Erfindung.

In einer bevorzugten Variante sind die Elektroden aus einem elektrisch leitfähigen Kunststoff gefertigt. Dies erlaubt die gleichzeitige Herstellung der Elektroden mit einem Kunststoff- Bauteil eines Kraftfahrzeugs, in dem sie anzuordnen sind. Hierbei wird ein inniger Verbund der Materialien erzielt, so dass einerseits insgesamt die mechanische Stabilität des Bauteils nicht beeinträchtigt wird und andererseits die Elektroden in dem Bauteil eingebettet sind. Die Festigkeit der Elektroden ist sehr hoch; ein Ablösen von dem Bauteil ist praktisch nicht möglich. Sie werden z.B. einfach auf das Kunststoff- Bauteil an den vorgesehenen Stellen aufgespritzt. Der Fertigungsaufwand für das Bauteil wird durch die integrierten Elektroden nur sehr gering erhöht.

In einer Ausgestaltung der Erfindung sind die Elektroden aus einem schwach leitfähigen Kunststoff gefertigt. Geeignete Materialien sind z.B. mit Leitruß versetztes Polypropylen, Ethylenvinylacetat oder Polyamid sowie Polytiophen, Polyanilin oder Polypyrrol. Diese Kunststoffe sind preiswert erhältlich und leicht zu verarbeiten.

In einer weitern Ausgestaltung erfolgt der elektrische Anschluss der Elektroden kapazitiv gekoppelt. Dies gewährleistet für die Anwendung des Näherungssensors einen sicheren und einfach herzustellenden Anschluss.

In einer weiteren Ausgestaltung sind die Elektroden in einem Heckdiffusor eines Kraftfahrzeugs angeordnet. Dies ist besonders für das automatische Betätigen einer Heckklappe geeignet.

In einer weiteren Ausgestaltung ist die Elektronik in einem Endbereich der Elektroden mechanisch befestigt. Hierbei sind die Elektronik und der kontaktlose Anschluss auf einer Platine angeordnet, so dass zusätzliche Bauteile für den Anschluss entfallen.

Der Näherungssensor ist vorzugsweise als kapazitiver Sensor ausgebildet, weil dieser sich hierfür wegen seiner sehr niedrigen Stromaufnahme bewährt hat.

In einer alternativen Ausgestaltung ist eine Koppelfläche als massiver kegel- oder keilförmiger Dorn ausgebildet, wobei in den Elektroden entsprechende Aussparungen angeordnet sind. Dies minimiert den Abstand zwischen der Koppelfläche und der Elektrode, so dass eine optimale Kopplung erfolgt. Weiterhin wird die Positionierung der Leiterplatte zu der Elektrode erleichtert.

Anhand der beigefügten Zeichnungen wird die Erfindung nachfolgend näher erläutert. Dabei zeigt:
- Fig. 1: einen schematischen Aufbau eines Näherungssensors,
- Fig. 2: ein Schema eines Näherungssensors am Beispiel einer automatischen Tür oder Klappe und
- Fig. 3: einen schematischen Aufbau eines anderen Näherungssensors, wobei eine Leiterplatte explosionsartig abgenommen ist.

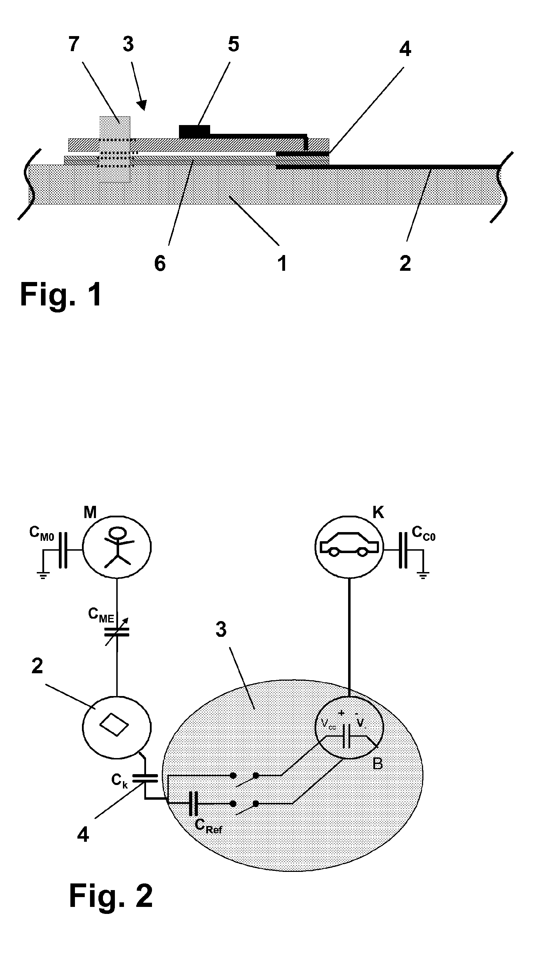

Wie aus der Figur 1 ersichtlich sind auf einem elektrisch nicht leitenden KunststoffBauteil 1, hier einem Heckdiffusor eines Kraftfahrzeugs, zwei parallel verlaufende Elektroden 2 angeordnet. Jede der Elektroden 2 weist bei einer geringen Dicke von z.B. 1 mm in der Draufsicht eine längliche rechteckige Form auf. Die Elektroden 2 sind aus einem schwach leitfähigen Kunststoff gefertigt.

Über benachbarten Enden der Elektroden 2 ist eine Leiterplatte 3 so angeordnet, dass zwei an ihr angeordnete Koppelflächen 4 den genannten Enden zugeordnet sind. Das bedeutet, dass über jedem der Enden eine der Koppelflächen 4 ist. Jede der Koppelflächen 4 ist als flächige Leiterbahn aus Metall wie z.B. Kupfer auf einer den Elektroden 2 zugewendeten Seite der Leiterplatte 3 ausgebildet und mittels einer Leiterbahn mit einer Elektronik 5 verbunden. Die Elektronik 5 ist in Form einer Vielzahl von elektrischen und/oder elektronischen Bauteilen auf der Leiterplatte 3 ausgebildet, wovon eines exemplarisch dargestellt ist. Die den Koppelflächen 4 zugeordnete Seite der Leiterplatte 3 ist zumindest im Bereich der Koppelflächen 4 mit einer Isolierung 6 beschichtet.

Die Lage der Leiterplatte 3 ist mittels mindestens einer Positionsmarke 7 zu den Elektroden 2 ausrichtbar. Hier sind zwei Positionsmarken 7 als Rastelemente ausgebildet, die neben der Ausrichtung auch eine lösbare Befestigung der Leiterplatte 3 auf dem Kunststoffteil 1 gewährleisten. Die Leiterplatte 3 ist vorzugsweise von einem nicht dargestellten Gehäuse vor mechanischer Belastung, Staub und Spritzwasser/ Feuchtigkeit geschützt.

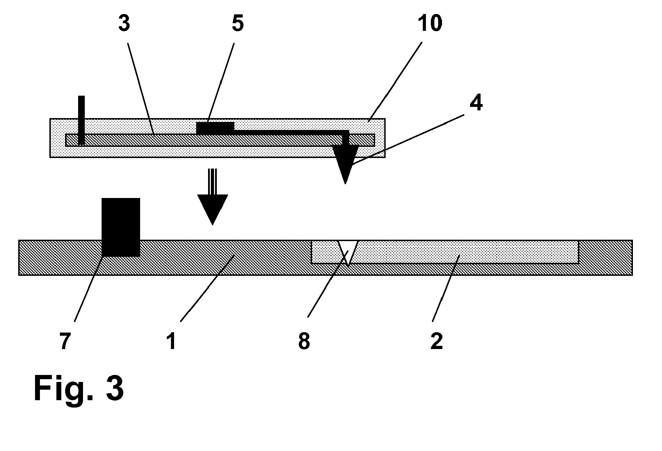

In der Figur 3 ist ein anderes Beispiel der kapazitiven Anbindung der Elektroden 2 an die Leiterplatte 3 dargestellt; es unterscheidet sich von dem vorigen Beispiel durch Folgendes:

Die Koppelflächen 4 sind als massive kegel- oder keilförmige Dorne aus leitfähigem Material ausgeführt und ragen mit ihren Spitzen in Richtung der Elektroden 2 aus der Leiterplatte 3 heraus. In den Elektroden 2 sind entsprechende, also kegel- oder keilförmige Aussparungen 8 angeordnet. Die Größe und die Positionierung der Aussparungen 8 entspricht den Dornen, so dass bei montiertem Näherungssensor die Dorne in den Aussparungen 8 sind. Hierbei ist ein Abstand zwischen den Dornen und den Wandungen der zugeordneten Aussparungen 8 sehr gering. Dieser Abstand entsteht beispielsweise durch eine nicht dargestellte Oxidschicht auf den als Dornen ausgebildeten Koppelflächen 4 und/oder den Wandungen der zugeordneten Aussparungen 8. Hierdurch ist ein sichererer elektrischer Anschluss der Elektrode (2) an die Elektronik (5) allein durch die Kontaktierung nicht gewährleistet. Deshalb ist erfindungsgemäß ein kontaktloser elektrischer Anschluss der Elektrode (2) an die Elektronik (5) vorgesehen.

Die Leiterplatte 3 ist von einer isolierenden Vergussmasse 10 umgeben. Die Koppelflächen 4 sind in einem Bereich der Spitzen nicht isoliert.

Nach der Figur 2 ist der Näherungssensor dem Kraftfahrzeug K zugeordnet. Wenn eine Person M in die Nähe des Näherungssensors kommt, ändert sich die Kapazitätswirkung zwischen der Person M und den Elektroden 2. Diese Änderung wird in der Elektronik 5 bestimmt und ausgewertet. Im Normalfall entspricht eine auszuwertende Kapazitätsänderung einer Kapazität C_{ME} zwischen der Person M und den Elektroden 2. Eine Kapazität C_{K} aus der kontaktlosen Koppelung spielt für die Auswertung praktisch keine Rolle, weil sie statisch ist und meistens sehr viel größer als die Kapazität C_{ME} zwischen der Person M und den Elektroden 2.

Die Auswertung der Signale der Elektroden 2 in der Elektronik 5 erfolgt auf bekannte Weise.

Für die Fertigung des Näherungssensors wird das Kunststoff- Bauteil 1 zusammen mit den Positionsmarken 7 im z.B. Spritzguss hergestellt. Im selben oder in einem weiteren Arbeitsgang werden die Elektroden 2 aufgespritzt. Die Leiterplatte 3 mit der Elektronik 5 wird separat gefertigt. Das Aufrasten der Leiterplatte 3 kann entweder als Vormontage oder mit einer Endmontage des Kraftfahrzeugs erfolgen.

## Patentansprüche

1. Näherungssensor, umfassend
mindestens eine Elektrode (2)
und eine Elektronik (5) zum Auswerten der Signale der Elektrode (2), **dadurch gekennzeichnet, dass** ein elektrischer Anschluss der Elektrode (2) an die Elektronik (5) kontaktlos erfolgt.

2. Näherungssensor nach Anspruch 1, **dadurch gekennzeichnet, dass** die Elektrode (2) aus einem leitfähigen Kunststoff gefertigt ist.

3. Näherungssensor nach Anspruch 2, **dadurch gekennzeichnet, dass** die Elektrode (2) aus einem schwach leitfähigen Kunststoff gefertigt ist.

4. Näherungssensor nach einem der Ansprüche 1 bis 3, **dadurch gekennzeichnet, dass** der elektrische Anschluss der Elektrode (2) kapazitiv erfolgt.

5. Näherungssensor nach einem der Ansprüche 1 bis 4, **dadurch gekennzeichnet, dass** die Elektrode (2) in einem Kunststoffteil ausgebildet ist, das in einem Heckbereich eines Kraftfahrzeugs angeordnet ist.

6. Näherungssensor nach einem der Ansprüche 1 bis 5, **dadurch gekennzeichnet, dass** die Elektronik (5) in einem Endbereich der Elektrode (2) mechanisch befestigt ist.

7. Näherungssensor nach einem der Ansprüche 1 bis 6, **dadurch gekennzeichnet, dass** er als kapazitiver Sensor ausgebildet ist.

8. Näherungssensor nach einem der Ansprüche 1 bis 7, **dadurch gekennzeichnet, dass** eine Koppelfläche (4) als massiver kegel- oder keilförmiger Dorn ausgebildet ist, wobei in den Elektroden (2) entsprechende Aussparungen (8) angeordnet sind.
